# EUROPEAN PATENT SPECIFICATION

(11) **EP 1 930 968 B1**
(45) Date of publication and mention of the grant of the patent: **27.04.2016**
(21) Application number: 07254721.9
(22) Date of filing: 06.12.2007
(51) Int. Cl.: H01L 51/52, H01L 27/32

(54) **Organic light emitting display apparatus**
Organische lichtemittierende Vorrichtung
Appareil d'affichage électroluminescent organique

(30) Priority: 06.12.2006 KR 20060123371
(43) Date of publication of application: 11.06.2008
(73) Proprietor: Samsung Display Co., Ltd., Gyeonggi-do (KR)
(72) Inventor: Lee, Byoung-Duk, c/o Samsung SDI Co. Ltd., Suwon-si, Gyeonggi-do (KR); Lee, Jong-Hyuk, c/o Samsung SDI Co. Ltd., Suwon-si, Gyeonggi-do (KR); Cho, Yoon-Hyeung, c/o Samsung SDI Co. Ltd., Suwon-si, Gyeonggi-do (KR); Oh, Min-Ho, c/o Samsung SDI Co. Ltd., Suwon-si, Gyeonggi-do (KR); Lee, So-Young, c/o Samsung SDI Co. Ltd., Suwon-si, Gyeonggi-do (KR); Lee, Sun-Young, c/o Samsung SDI Co. Ltd., Suwon-si, Gyeonggi-do (KR); Kim, Won-Jong, c/o Samsung SDI Co. Ltd., Suwon-si, Gyeonggi-do (KR); Kim, Yong-Tak, c/o Samsung SDI Co. Ltd., Suwon-si, Gyeonggi-do (KR); Choi, Jin-Baek, c/o Samsung SDI Co. Ltd., Suwon-si, Gyeonggi-do (KR)
(74) Representative: Mounteney, Simon James

(56) References cited:
- EP-A1- 1 441 571
- EP-A2- 1 585 175
- WO-A1-2006/001310
- WO-A1-2006/125988
- US-A1- 2002 030 440
- US-A1- 2003 027 369
- US-A1- 2003 080 679
- US-A1- 2003 146 446
- US-A1- 2003 183 830
- US-B1- 6 410 168

## Description

### CROSS-REFERENCE TO RELATED PATENT APPLICATION

### BACKGROUND OF THE INVENTION

### 1. Field of the Invention

The present invention relates to an organic light emitting display apparatus and more particularly, to an organic light emitting display apparatus with increased contrast and impact resistance.

### 2. Description of the Related Art

It is recent trend that display apparatuses are replaced by thin flat panel display apparatuses that can be used in mobile applications. Of the flat panel display apparatuses, organic and inorganic organic light emitting display apparatuses are expected to be next generation display apparatuses due to the advantages in that the organic and inorganic organic light emitting display apparatuses are emissive type display apparatuses and have a wide viewing angle, high contrast, and a short response time. Organic light emitting display apparatuses in which a light emitting layer is formed of an organic material have characteristics such as higher brightness, a low driving voltage, and a short response time, which are superior to those of the Inorganic light emitting display apparatus, and can also be multi-colored.

Flat panel display apparatuses are formed to be lightweight and thin so that can be portable and be used outdoors. When a flat panel display apparatus is used outdoors, the contrast and visibility can be reduced due to the reflection of sunlight. In particular, for organic light emitting display apparatuses, the reflection of sunlight caused by a metal reflection film of the organic light emitting display apparatuses can be severe.

Also, there is a high possibility that an external surface of the organic light emitting display apparatuses can be easily damaged by external impact.

US2003183830 discloses a light emitting device having an organic compound layer formed from laminated sections by means of intentionally and partially overlapping different organic compound layers of adjacent light emitting elements.

US2003/0146446 discloses an organic light emitting display having a substrate, organic light emitting elements on the substrate and a sealing member. A diamond-like carbon layer is formed on both surfaces of a plastic film which is positioned on an opposite surface of the substrate to the organic light emitting elements.

EP1441571 discloses an organic light emitting display having a substrate, organic light emitting elements on the substrate and a sealing panel. A colour filter is located on an internal surface of the sealing panel facing the organic light emitting elements.

US2003/0027369 discloses an organic light emitting display having a sealing member and an inorganic insulating film.

US2002/0030440 discloses an organic light emitting display having light emitting elements formed on a flexible film.

### SUMMARY OF THE INVENTION

The present invention provides an organic light emitting display apparatus with increased contrast and impact resistance.

According to an aspect of the present invention, there is provided an organic light emitting display apparatus as set out in Claim 1. Preferred features of this aspect are set out in Claims 2 to 10.

### BRIEF DESCRIPTION OF THE DRAWINGS

The above and other features and advantages of the present invention will become more apparent by describing in detail exemplary embodiments thereof with reference to the attached drawings in which:
FIG. 1 is a schematic cross-sectional view illustrating an organic light emitting display apparatus according to an embodiment of the present invention;
FIGS. 2 through 4 are schematic cross-sectional views illustrating modified versions of the organic light emitting display apparatus of FIG. 1, according to an embodiment of the present invention; and
FIG. 5 is a schematic cross-sectional view illustrating an organic light emitting display apparatus according to another embodiment of the present invention.

### DETAILED DESCRIPTION OF THE INVENTION

The present invention will now be described more fully with reference to the accompanying drawings in which exemplary embodiments of the invention are shown.

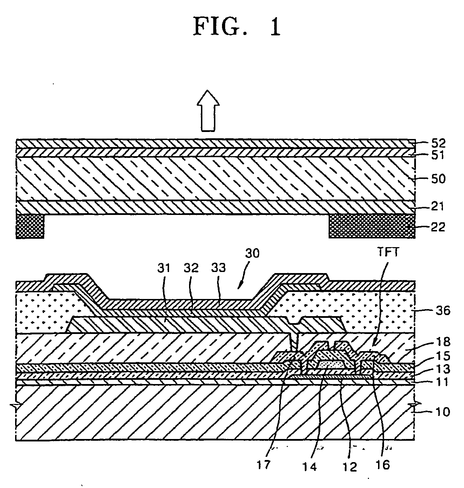

FIG. 1 is a schematic cross-sectional view illustrating an organic light emitting display apparatus according to an embodiment of the present invention. Organic light emitting display apparatuses are largely classified as active matrix (AM) type organic light emitting display apparatuses and passive matrix (PM) type organic light emitting display apparatuses. The organic light emitting display apparatus depicted in FIG. 1 is an AM type organic light emitting display apparatus, however, embodiments of the present invention are not limited thereto and can also be a PM type organic light emitting display apparatus.

Referring to FIG. 1, the organic light emitting display apparatus according to an embodiment of the present invention includes a substrate 10, an organic light emitting device 30, a sealing member 50, a semi-transparent film 51, a passivation film 52, a transmissive black layer 21, and a black matrix layer 22.

The substrate 10 can be formed of a transparent glass material having SiO₂ as a main component. However, the substrate 10 is not limited thereto. That is, the substrate 10 can be formed of a transparent plastic material. In the case of a bottom emission type organic light emitting display apparatus in which an image is displayed through the substrate 10, the substrate 10 must be formed of a transparent material. However, as depicted in FIG. 1, in the case of a top emission type organic light emitting display apparatus in which an image is displayed through the sealing member 50, the substrate 10 is not necessarily formed of a transparent material.

In this embodiment, a buffer layer 11 is be formed on an upper surface of the substrate 10 to secure planarity of the substrate 10 and to prevent impure elements from penetrating into the organic light emitting display apparatus. The buffer layer 11 can be formed of at least one of SiO₂ and SiNx.

A thin film transistor (TFT) is formed on the upper surface of the substrate 10. At least one TFT is formed in each pixel and is electrically connected to the organic light emitting device 30.

More specifically, a semiconductor layer 12 having a predetermined pattern is formed on the buffer layer 11. The semiconductor layer 12 can be formed of an inorganic or organic semiconductor such as an amorphous silicon or poly silicon, and includes a source region, a drain region, and a channel region.

A gate insulating film 13 is formed of SiO2 or SiNx on an upper surface of the semiconductor layer 12 and the buffer layer 11, and a gate electrode 14 is formed in a predetermined region on an upper surface of the gate insulating film 13. The gate electrode 14 is connected to a gate line (not shown) that applies an ON/OFF signal to the TFT.

An interlayer insulating layer 15 is formed on the gate electrode 14, and a source electrode 16 and a drain electrode 17 are respectively connected to the source region and the drain region of the semiconductor layer 12 through contact holes. The TFT is protected by a passivation film 18, which can be at least one of an inorganic insulating film and an organic insulating film. The inorganic insulating film can be formed of SiO₂, SiNx, SiON, Al₂O₃, TiO₂, Ta₂O₅, HfO₂, ZrO₂, BST, or PZT. The organic insulating film can be formed of ordinary multi-purpose polymers such as polymethyl methacrylate or polystyrene, polymer derivatives having a phenol group, an acryl polymer, an imide polymer, an arylester polymer, an amide polymer, a fluoride polymer, a p-gilyrene polymer, a vinyl alcohol polymer, or a mixture of these polymers. The passivation film 18 can be formed as a composite stack of an inorganic insulating film and an organic insulating film.

A first electrode 31 that functions as an anode electrode of the organic light emitting device 30 is formed on the passivation film 18, and a pixel defining layer 36 covering the first electrode 31 is formed of an insulating material. After a predetermined opening is formed in the pixel defining layer 36, an organic light emitting layer 32 of the organic light emitting device 30 is formed in a region defined by the opening. Afterwards, a second electrode 33 that functions as a cathode electrode of the organic light emitting device 30 is formed to cover the entire pixel. The polarity of the first electrode 31 and the second electrode 33 may be reversed.

The organic light emitting device 30 displays an image by emitting light according to current flow, and includes the first electrode 31 electrically connected to the drain electrode 17 of the TFT through a contact hole, the organic light emitting layer 32, and the second electrode 33.

The first electrode 31 can be formed in a predetermined pattern using a photolithography method. In a PM type organic light emitting display apparatus, the pattern of the first electrode 31 can be formed in a stripe shape separated by a predetermined distance, and in an AM type organic light emitting display apparatus, the pattern of the first electrode 31 can be formed in a shape corresponding to the shape of the pixel. The second electrode 33 is disposed above the first electrode 31, and can be used as a cathode electrode by connecting to an external terminal (not shown). In the case of a PM type organic light emitting display apparatus, the second electrode 33 can be formed in a stripe shape crossing the pattern of the first electrode 31, and in the case of the AM type organic light emitting display apparatus, the second electrode 33 can be formed on the entire region where an image is displayed. The polarity of the first electrode 31 and the second electrode 33 may be reversed. In the case of a bottom emission type organic light emitting display apparatus in which an image is displayed through the substrate 10, the first electrode 31 is a transparent electrode, and the second electrode 33 can be a reflection electrode. The first electrode 31 is formed of a material having a high work function such as ITO, IZO, ZnO, or In₂O₃, and the second electrode 33 can be formed of a metal having a low work function such as Ag, Mg, Al, Pt, Pd, Au, Ni, Nd, Ir, Cr, Li, or Ca.

In the case of a top emission type organic light emitting display apparatus in which an image is displayed through the second electrode 33, the first electrode 31 can be a reflection electrode and the second electrode 33 can be a transparent electrode. In this case, the reflection electrode that functions as the first electrode 31 is formed on the reflection film using a material having a high work function such as ITO, IZO, ZnO, or In₂O₃. The reflection film is formed using a metal such as Ag, Mg, Al, Pt, Pd, Au, Ni, Nd, Ir, Cr, Li, Ca, or compound of these metals. The transparent electrode that functions as the second electrodes 33 can be formed by depositing a metal such as Ag, Mg, Al, Pt, Pd, Au, Ni, Nd, Ir, Cr, Li, Ca, or a compound of these metals having a small work function and by forming an auxiliary electrode layer or a bus electrode line using a transparent conductive material such as ITO, IZO, ZnO, or In₂O₃ on the metal deposition.

In the case of a dual side emission type organic light emitting display apparatus, the first and second electrodes 31 and 33 can be formed as transparent electrodes.

The organic light emitting layer 32 that is interposed between the first electrode 31 and the second electrode 33 emits light according to electrical driving of the first electrode 31 and the second electrode 33. The organic light emitting layer 32 can be formed of a low molecular weight organic material or a polymer organic material. When the organic light emitting layer 32 is formed of a low molecular weight organic material, a hole transport layer (HTL) and a hole injection layer (HIL) are stacked in a direction towards the first electrode 31 from the organic light emitting layer 32, and an electron transport layer (ETL) and an electron injection layer (EIL) are stacked in a direction towards the second electrode 33 from the organic light emitting layer 32. Besides these layers, various other layers can be stacked if necessary. The low molecular weight organic material of the organic light emitting layer 32 can be of various materials including copper phthalocyanine (CuPc), N,N'-Di(naphthalene-1-yl)-N,N'-diphenyl-benzidine (NPB), and tris-8-hydroxyquinoline aluminum (Alq3).

When the organic light emitting layer 32 is formed of a polymer organic material, an HTL is formed in a direction towards the first electrode 31 from the organic light emitting layer 32. The polymer HTL can be formed on the first electrode 31 using poly-(2,4)-ethylene-dihydroxy thiophene (PEDOT) or polyaniline (PANI) by an inkjet printing or a spin coating method. The polymer organic light emitting layer 32 can be formed of poly-phenylenevinylene (PPV), soluble PPV's, cyano-PPV, or polyfluorene and a color pattern is formed using conventional methods such as an inkjet printing method, a spin coating method, or a thermal transcribing method using a laser.

The sealing member 50 that seals the organic light emitting device 30 is formed on the organic light emitting device 30. The sealing member 50 protects the organic light emitting device 30 from external moisture or oxygen. In the top emission type organic light emitting display apparatus as depicted in FIG. 1, the sealing member 50 is formed of a transparent material. For this purpose, the top emission type organic light emitting display apparatus can be a structure in which a plurality of layers such as a glass substrate, a plastic substrate, or organic and inorganic materials are stacked.

The semi-transparent film 51 that transmits a part of external light and reflects another part of the external light is formed on an upper surface of the sealing member 50 facing the outside. The semi-transparent film 51 may be formed to have reflectance of 1.5 to 5. The semi-transparent film 51 can be formed in a metal colloid using a metal such as Ag, Au, or Ti. The semi-transparent film 51 can be easily formed by an annealing process after a metal colloid film is coated by spin coating, dip coating or bar coating. The semi-transparent film 51 is formed to have an optical transmittance of 40 to 80% by controlling the thickness of the semi-transparent film 51 or the process conditions when the metal colloid is formed. The semi-transparent film 51 can be formed to have a thickness of 10 nm to 10 *µ*m. If the thickness of the semi-transparent film 51 is excessively thick, the optical transmittance of the semi-transparent film 51 is reduced and thus, resulting in reducing the optical efficiency of light emitted from the organic light emitting device 30. Therefore, the semi-transparent film 51 is formed to a thickness of less than 10 *µ*m. If the thickness of the semi-transparent film 51 is excessively thin, the optical transmittance of the semi-transparent film 51 excessively increases. Thus, external light can pass through the semi-transparent film 51, and as a result, the amount of external light to be reflected by the reflection electrode increases.

The passivation film 52 is formed on the semi-transparent film 51. The passivation film 52 is formed to have a refractive index that is less than that of the semi-transparent film 51. The passivation film 52 is formed of a thermosetting resin having high impact resistance, such as urethane acrylate or epoxy resin. Thus, the passivation film 52 is transparent. More specifically, the passivation film 52 can be formed by a hardening process using annealing or ultraviolet rays after coating a film by spin coating, dip coating or bar coating. The passivation film 52 can be formed to a thickness of 10 nm to 30 *µ*m in some embodiments. The passivation film 52 is formed to a thickness of 10 nm or more to secure impact resistance in some embodiments. However, if the thickness is excessively thick, an overall thickness of the organic light emitting display apparatus increases. Therefore in some embodiments, the passivation film 52 is formed to a thickness of 30 *µ*m or less.

The passivation film 52 is formed of a thermosetting resin with high impact resistance and able to protect the thin semi-transparent film 51 from external impact.

The organic light emitting display apparatus according to this embodiment of the present embodiment has a structure in which the semi-transparent film 51 and the passivation film 52 are formed as an overlapping structure on the sealing member 50 and the semi-transparent film 51 has a refractive index greater than that of the passivation film 52, thereby preventing the reflection of external light at an interface of the passivation film 52. That is, the combination of the semi-transparent film 51 and the passivation film 52 can function as a conventional circular polarizer. In particular, the optical transmittance of the organic light emitting display apparatus according to this embodiment of the present embodiment can easily match the optical transmittance of a conventional circular polarizer by combining the semi-transparent film 51 having an optical transmittance of 40 to 80% and the passivation film 52 that is formed of a transparent material.

The transmissive black layer 21 is formed between the sealing member 50 and the organic light emitting device 30. Referring to FIG. 1, the transmissive black layer 21 is formed on a surface of the sealing member 50 facing the organic light emitting device 30. The transmissive black layer 21 can be formed of graphite or diamond like carbon (DLC) at a temperature of 250°C or less to prevent the transmissive black layer 21 and organic light emitting device 30 from degradation using a sputtering method or a chemical vapor deposition (CVD) method.

The transmissive black layer 21 is a partially transmissive layer that increases contrast of the organic light emitting display apparatus. In order to increase contrast of the organic light emitting display apparatus, the transmissive black layer 21 must have an appropriate optical transmittance. A low optical transmittance is advantageous for increasing contrast of the organic light emitting display apparatus. However, a low optical transmittance reduces the extraction rate of light generated from the organic light emitting device 30. In particular, the optical transmittances of the semi-transparent film 51 and the passivation film 52 must also be considered. In some embodiments of the invention the transmissive black layer 21 is formed to have an optical transmittance of 35 to 80%. As a result of this, the optical transmittance of the organic light emitting display apparatus according to the present embodiment can be controlled from 40 to 60% even when the transmissive black layer 21, the semi-transparent film 51, and the passivation film 52 are simultaneously used. That is the organic light emitting display apparatus according to the present embodiment can prevent reflection of external light and can increase contrast while maintaining an optical transmittance of approximately 40%, which is the optical transmittance of a conventional circular polarizer, or higher even when the transmissive black layer 21, the semi-transparent film 51, and the passivation film 52 are simultaneously used. The transmissive black layer 21 can include 5 to 35% hydrogen so that the transmissive black layer 21 that is formed of graphite or DLC can have a desired optical transmittance.

The desired optical transmittance of the organic light emitting display apparatus can be obtained by controlling the thickness of the transmissive black layer 21. Thus, in order to increase the optical transmittance of the organic light emitting display apparatus, the thickness of the transmissive black layer 21 is increased, and in order to reduce the optical transmittance of the organic light emitting display apparatus, the thickness of the transmissive black layer 21 is reduced. In some embodiments of the invention, the transmissive black layer 21 having a desired optical transmittance can be obtained by forming the transmissive black layer 21 to a thickness of 5 to 70 nm.

The transmissive black layer 21 having an appropriate thickness can be formed by considering conditions of using the semi-transparent film 51, the passivation film 52, and the organic light emitting display apparatus according to the present embodiment.

The contrast of the organic light emitting display apparatus according to the present embodiment can further increase due to the formation of the transmissive black layer 21.

The black matrix layer 22 can be formed on the transmissive black layer 21. The black matrix layer 22 is patterned to be disposed in a non-display region of the organic light emitting device 30. The black matrix layer 22 comprises a plurality of light absorbing portions formed in regions corresponding to non-display regions of the organic light emitting device. A display region of the organic light emitting device 30 is a region where the organic light emitting layer 32 is located, and the non-display region of the organic light emitting device 30 is the rest regions where the organic light emitting layer 32 is not located. The black matrix layer 22 can be formed of graphite or chrome having a strong dark color in order to absorb external light, however, the black matrix layer 22 can also be formed of any material that can absorb external light.

The organic light emitting display apparatus according to the present embodiment includes the semi-transparent film 51 and the passivation film 52 having a refractive index lower than that of the semi-transparent film 51 and having a high impact resistance on the sealing member 50. Thus, the reflection of external light, in particular, at an interface of the substrate 10 can be reduced and an external surface of the organic light emitting display apparatus can be protected from external impact.

Also, the transmissive black layer 21 is formed between the organic light emitting device 30 and the sealing member 50 in order to control the optical transmittance of the organic light emitting display apparatus, thereby increasing contrast of the organic light emitting display apparatus. The contrast of the organic light emitting display apparatus can be further increased by forming the black matrix layer 22 in the non-display region of the organic light emitting device 30.

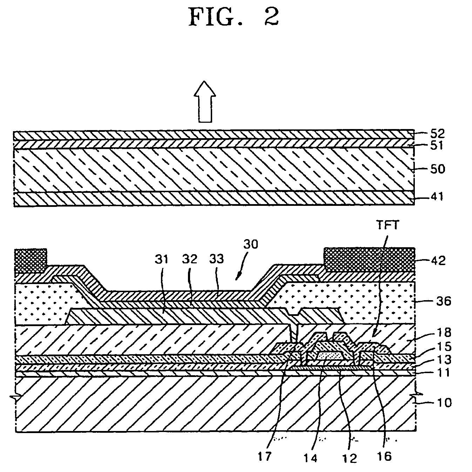

FIGS. 2 through 4 are schematic cross-sectional views illustrating modified versions of the organic light emitting display apparatus of FIG. 1, according to other embodiments of the present invention. Hereinafter, the differences from the organic light emitting display apparatus of FIG. 1 will be mainly described. Like reference numerals are used to indicate elements that are substantially identical to the elements of FIG. 1.

Referring to FIG. 2, the organic light emitting display apparatus according to the present embodiment includes the substrate 10, the organic light emitting device 30, the sealing member 50, the semi-transparent film 51, the passivation film 52, a transmissive black layer 41, and a black matrix layer 42. The transmissive black layer 41 is formed on a surface of the sealing member 50 facing the organic light emitting device 30. The black matrix layer 42 is formed on the second electrode 33. The rest of the structure is identical to the organic light emitting display apparatus of FIG. 1, and thus, the detailed description thereof will not be repeated.

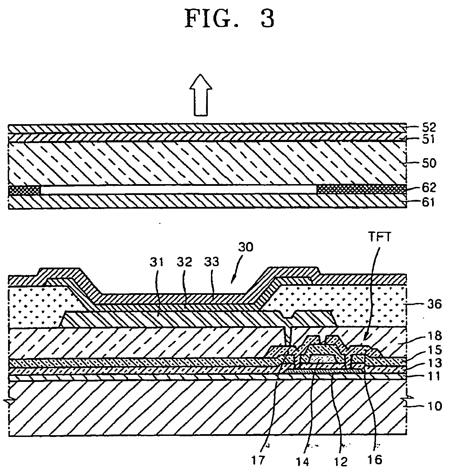

Referring to FIG. 3, the organic light emitting display apparatus according to the present embodiment includes the substrate 10, the organic light emitting device 30, the sealing member 50, the semi-transparent film 51, the passivation film 52, a transmissive black layer 61, and a black matrix layer 62. The black matrix layer 62 and the transmissive black layer 61 are sequentially formed on a surface of the sealing member 50 facing the organic light emitting device 30. In detail, the black matrix layer 62 is formed between the sealing member 50 and the transmissive black layer 61.

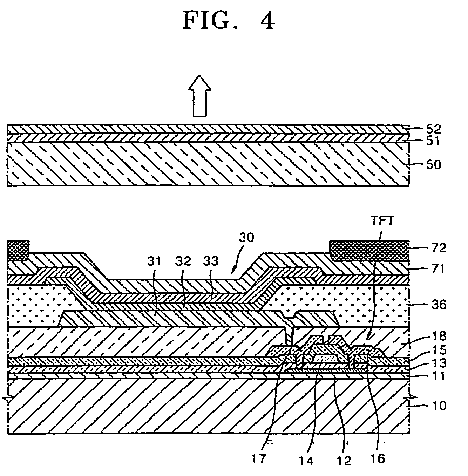

Referring to FIG. 4, the organic light emitting display apparatus according to the present embodiment includes the substrate 10, the organic light emitting device 30, the sealing member 50, the semi-transparent film 51, the passivation film 52, a transmissive black layer 71, and a black matrix layer 72. The transmissive black layer 71 is formed on the second electrode 33 of the organic light emitting device 30. The patterned black matrix layer 72 is formed on the transmissive black layer 71.

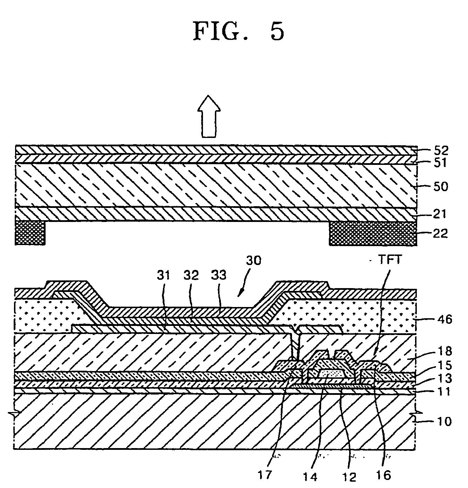

FIG. 5 is a schematic cross-sectional view illustrating an organic light emitting display apparatus according to another embodiment of the present invention. The differences between the an organic light emitting display apparatus of FIG. 5 and the organic light emitting display apparatus of FIG. 1 will be mainly described. Like reference numerals are used to indicate elements that are substantially identical to the elements of FIG. 1.

Referring to FIG. 5, the organic light emitting display apparatus according to the present embodiment includes a substrate 10, an organic light emitting device 30, a sealing member 50, a semi-transparent film 51, a passivation film 52, a pixel defining film 46, a transmissive black layer 21, and a black matrix layer 22.

A first electrode 31 that functions as an anode electrode of the organic. light emitting device 30 is formed on a passivation film 18, and the pixel defining layer 46 covering the passivation film 18 is formed using an insulating material. After forming a predetermined opening in the pixel defining layer 46, an organic light emitting layer 32 of the organic light emitting device 30 is formed in a region defined by the opening. Afterwards, a second electrode 33 that functions as a cathode electrode of the organic light emitting device 30 is formed to cover the entire pixels. The polarity of the first electrode 31 and the second electrode 33 may be reversed. The pixel defining layer 46 can be formed to have a strong dark color as an insulating layer, and in this case, the reflection of external light can be minimized, thereby increasing contrast of the organic light emitting display apparatus. In other words, the pixel defining layer 46 acts as an insulating film that absorbs light.

The organic light emitting display apparatus of FIG. 5 can also be modified as the organic light emitting display apparatus of FIG. 1 is modified as illustrated in FIGS. 2 through 4.

An organic light emitting display apparatus according to the present invention has increased contrast.

While the present invention has been particularly shown and described with reference to exemplary embodiments thereof, it will be understood by one of ordinary skill in the art that various changes in form and details may be made therein without departing from the scope of the present invention as defined by the following claims.

## Claims

1. An organic light emitting display apparatus comprising:
a substrate (10);
an organic light emitting device (30) disposed over the substrate (10);
a sealing member (50) formed over the organic light emitting device (30);
and
a partially transmissive layer (21, 41, 61, 71) formed between the sealing member (50) and the organic light emitting device (30), the partially transmissive layer (21, 41, 61) being arranged to increase contrast of images displayed by the organic light emitting display (30);
**characterised by**:
a semitransparent film (51) formed over an upper surface of the sealing member (50), the semitransparent film (51) being arranged to transmit a portion of external light and to reflect another portion of external light; and
a passivation film (52) formed over the semitransparent film so as to cover the semitransparent film, the passivation film (52) being arranged to protect the semitransparent film (51);
wherein the partially transmissive layer (21, 41, 61) has an optical transmittance of 35 to 80%; and
wherein the semitransparent film (51) has a refractive index greater than that of the passivation film (52) and an optical transmittance of 40 to 80%.

2. An organic light emitting display apparatus according to claim 1, wherein the partially transmissive layer (21, 41, 61) has a thickness of 5 to 70 nm

3. An organic light emitting display apparatus according to claim 1 or 2, further comprising:
a light absorbing matrix layer (42, 62) having light absorbing portions formed in regions corresponding to non-display regions of the organic light emitting device.

4. An organic light emitting display apparatus according to any of claims 1 to 3, wherein:
the organic light emitting device comprises a first electrode (31), a second electrode (33), and an organic light emitting layer (32) formed between the first electrode (31) and the second electrode (33); the apparatus further comprising:
an insulating film formed on the first electrode having an opening so as to expose the first electrode, the insulating film being arranged to absorb light.

5. An organic light emitting display apparatus according to any one of claims 1 to 4, wherein the partially transmissive layer (21, 41, 61) is formed of graphite or diamond like carbon (DLC).

6. An organic light emitting display apparatus according to any one of claims 1 to 5, wherein the passivation film (52) is formed of a thermosetting resin.

7. An organic light emitting display apparatus according to claim 6, wherein the passivation film (52) is formed of a urethane acrylate or an epoxy resin.

8. An organic light emitting display apparatus according to any one of claims 1 to 7, wherein the semitransparent film (51) has a refractive index of 1.5 to 5.0.

9. An organic light emitting display apparatus according to any one of claims 1 to 8, wherein the semitransparent film (51) is formed of a metal colloid.

10. An organic light emitting display apparatus according to any one of claims 1 to 9, wherein the semitransparent film (51) comprises Ag, Au, or Ti.

## Patentansprüche

1. Organische lichtemittierende Anzeigevorrichtung, umfassend:
ein Substrat (10);
eine organische lichtemittierende Vorrichtung (30), welche auf dem Substrat (10) angeordnet ist;
ein Dichtungselement (50), welches auf der organischen lichtemittierenden Vorrichtung (30) gebildet ist;
und
eine teilweise durchlässige Schicht (21, 41, 61, 71), welche zwischen dem Dichtungselement (50) und der organischen lichtemittierenden Vorrichtung (30) gebildet ist, wobei die teilweise durchlässige Schicht (21, 41, 61) so ausgebildet ist, dass sie den Kontrast der von der organischen lichtemittierenden Anzeige (30) angezeigten Bilder erhöht;
**gekennzeichnet durch**:
einen halbtransparenten Film (51), welcher auf einer oberen Fläche des Dichtungselements (50) gebildet ist, wobei der halbtransparente Film (51) ausgebildet ist, um einen Teil des Außenlichtes zu übertragen und einen anderen Teil des Außenlichtes zu reflektieren; und
einen Passivierungsfilm (52), welcher über dem halbtransparenten Film gebildet ist, um den halbtransparenten Film zu decken, wobei der Passivierungsfilm (52) ausgebildet ist, um den halbtransparenten Film (51) zu schützen;
wobei die teilweise durchlässige Schicht (21, 41, 61) eine optische Durchlässigkeit zwischen 35 und 80% aufweist; und
wobei der halbtransparente Film (51) einen Brechungsindex höher als der des Passivierungsfilms (52) und eine optische Durchlässigkeit zwischen 40 und 80% aufweist.

2. Organische lichtemittierende Anzeigevorrichtung nach Anspruch 1, wobei die teilweise durchlässige Schicht (21, 41, 61) eine Dicke von 5 bis 70 nm aufweist.

3. Organische lichtemittierende Anzeigevorrichtung nach Anspruch 1 oder 2, ferner umfassend:
eine lichtabsorbierende Matrixschicht (42, 62), welche lichtabsorbierende Teile aufweist, welche in Bereichen gebildet sind, welche zu Nicht-Anzeigebereichen der organischen lichtemittierenden Vorrichtung entsprechen.

4. Organische lichtemittierende Anzeigevorrichtung nach einem der Ansprüche 1 bis 3, wobei:
die organische lichtemittierende Vorrichtung eine erste Elektrode (31), eine zweite Elektrode (33), und eine organische lichtemittierende Schicht (32) aufweist, welche zwischen der ersten Elektrode (31) und der zweiten Elektrode (33) gebildet ist; wobei die Vorrichtung ferner umfasst:
einen Isolationsfilm, welcher auf der ersten Elektrode gebildet ist, und welcher eine Öffnung aufweist, um die erste Elektrode freizulegen, wobei der Isolationsfilm ausgebildet ist, um Licht zu absorbieren.

5. Organische lichtemittierende Anzeigevorrichtung nach einem der Ansprüche 1 bis 4, wobei die teilweise durchlässige Schicht (21, 41, 61) aus Graphit oder Diamantähnlichen Kohlenstoff (DLC) besteht.

6. Organische lichtemittierende Anzeigevorrichtung nach einem der Ansprüche 1 bis 5, wobei der Passivierungsfilm (52) aus einem wärmehärtenden Harz besteht.

7. Organische lichtemittierende Anzeigevorrichtung nach Anspruch 6, wobei der Passivierungsfilm (52) aus einem Urethanacrylat oder einem Epoxidharz besteht.

8. Organische lichtemittierende Anzeigevorrichtung nach einem der Ansprüche 1 bis 7, wobei der halbtransparente Film (51) einen Brechungsindex zwischen 1,5 und 5,0 aufweist.

9. Organische lichtemittierende Anzeigevorrichtung nach einem der Ansprüche 1 bis 8, wobei der halbtransparente Film (51) aus Metallkolloid besteht.

10. Organische lichtemittierende Anzeigevorrichtung nach einem der Ansprüche 1 bis 9, wobei der halbtransparente Film (51) Ag, Au oder Ti umfasst.

## Revendications

1. Appareil d'affichage électroluminescent organique, comprenant :
un substrat (10) ;
un dispositif électroluminescent organique (30) agencé sur le substrat (10) ;
un élément d'étanchéité (50) formé sur le dispositif électroluminescent organique (30) ; et
une couche partiellement transmissive (21, 41, 61, 71) formée entre l'élément d'étanchéité (50) et le dispositif électroluminescent organique (30), la couche partiellement transmissive (21, 41, 61) étant agencée afin d'augmenter un contraste d'images affichées grâce à l'affichage électroluminescent organique (30),
**caractérisé par** :
un film semi-transparent (51) formé sur une surface supérieure de l'élément d'étanchéité (50), le film semi-transparent (51) étant agencé afin de transmettre une partie de lumière externe et réfléchir une autre partie de lumière externe ; et
un film de passivation (52) formé sur le film semi-transparent de manière à recouvrir le film semi-transparent, le film de passivation (52) étant agencé de manière à protéger le film semi-transparent (51) ;
dans lequel la couche partiellement transmissive (21, 41, 61) présente un coefficient de transmission optique compris entre 35 et 80% ; et
dans lequel le film semi-transparent (51) présente un indice de réfraction supérieur à celui du film de passivation (52) et un coefficient de transmission optique compris entre 40 et 80%.

2. Appareil d'affichage électroluminescent organique selon la revendication 1, dans lequel la couche partiellement transmissive (21, 41, 61) présente une épaisseur de 5 et 70 nm.

3. Appareil d'affichage électroluminescent organique selon les revendications 1 ou 2, comprenant en outre :
une couche formant matrice d'absorption de lumière (42, 62) présentant des parties absorbant la lumière formées dans des régions correspondant à des régions de non-affichage du dispositif électroluminescent organique.

4. Appareil d'affichage électroluminescent organique selon l'une quelconque des revendications 1 à 3, dans lequel :
le dispositif électroluminescent organique comprend une première électrode (31), une deuxième électrode (33), et une couche électroluminescente organique (32) formée entre la première électrode (31) et la deuxième électrode (33) ; l'appareil comprenant en outre :
un film isolant formé sur la première électrode et présentant une ouverture de manière à exposer la première électrode, le film isolant étant agencé de manière à absorber la lumière.

5. Appareil d'affichage électroluminescent organique selon l'une quelconque des revendications 1 à 4, dans lequel la couche partiellement transmissive (21, 41, 61) est formée de graphite ou de carbone adamantin (DLC).

6. Appareil d'affichage électroluminescent organique selon l'une quelconque des revendications 1 à 5, dans lequel le film de passivation (52) est formé d'une couche thermodurcissable.

7. Appareil d'affichage électroluminescent organique selon la revendication 6, dans lequel le film de passivation (52) est formé d'une résine uréthane acrylate ou époxyde.

8. Appareil d'affichage électroluminescent organique selon l'une quelconque des revendications 1 à 7, dans lequel le film semi-transparent (51) présente un indice de réfraction compris entre 1,5 et 5,0.

9. Appareil d'affichage électroluminescent organique selon l'une quelconque des revendications 1 à 8, dans lequel le film semi-transparent (51) est formé d'un colloïde métallique.

10. Appareil d'affichage électroluminescent organique selon l'une quelconque des revendications 1 à 9, dans lequel le film semi-transparent (51) comprend Ag, Au, ou Ti.
